# EUROPÄISCHE PATENTSCHRIFT

(11) **EP 0 978 226 B1**
(45) Veröffentlichungstag und Bekanntmachung des Hinweises auf die Patenterteilung: **28.03.2001**
(21) Anmeldenummer: 98907841.5
(22) Anmeldetag: 21.01.1998
(51) Int. Cl.: H05K 13/04

(54) **SAUGPIPETTE ZUM GREIFEN VON ELEKTRISCHEN BAUELEMENTEN**
SUCKING PIPETTE FOR PICKING UP ELECTRIC COMPONENTS
PIPETTE ASPIRANTE SERVANT A SAISIR DES COMPOSANTS ELECTRIQUES

(30) Priorität: 30.01.1997 DE 19703402
(43) Veröffentlichungstag der Anmeldung: 09.02.2000
(73) Patentinhaber: SIEMENS AKTIENGESELLSCHAFT, 80333 München (DE)
(72) Erfinder: REIMANN, Günter, D-81375 München (DE)
(86) Internationale Anmeldenummer: DE9800179
(87) Internationale Veröffentlichungsnummer: WO9834453

(56) Entgegenhaltungen:
- EP-A- 0 277 731
- DE-U- 9 406 244
- US-A- 4 795 518
- PATENT ABSTRACTS OF JAPAN vol. 16, no. 154 (E-1190), 15.April 1992 & JP 04 007900 A (SHARP), 13.Januar 1992,

## Beschreibung

Die Erfindung bezieht sich auf eine Pipette zum Greifen von Bauelementen mittels Vakuum, insbesondere beim Bestücken von Leiterplatten.

Eine derartige Pipette ist z.B. durch das deutsche Gebrauchsmuster 94 06 244 bekannt geworden. Danach weist die Pipette auf ihrer, dem Bauelement zugewandten Stirnseite eine Saugöffnung auf. Das Bauelement ist gegen eine die Saugöffnung umgebende Auflagefläche der Stirnseite ansaugbar. Die Auflagefläche ist Teil eines elastomeren Auflagekörpers, der in die Stirnseite eines Grundkörpers der Pipette eingesetzt ist und der die Stirnseite geringfügig überragt. Der Auflagekörper ist als O-Ring ausgebildet, der mit Preßsitz an der Innenwandung des Grundkörpers anliegt. Der O-Ring verbessert die Saugfähigkeit der Pipette, da er sich besser als ein harter Körper an die Oberfläche des angesaugten Bauelementes anschmiegt.

Beim Bestücken von Leiterplatten werden zunehmend Bestückautomaten verwendet, die einen verfahrbaren Revolverkopf aufweisen, der die Bauelemente aufnimmt, speichert, transportiert, auf ihre gewünschte Einbaulage verdreht, justiert und auf die Leiterplatte absetzt. Bei den verschiedenen Bewegungsvorgängen treten derartige Beschleunigungen auf, daß die Gefahr einer Lageveränderung des Bauelementes gegenüber der Pipette besteht. Die zulässige Lageabweichung ist jedoch so klein, daß eine derartige Lageveränderung unbedingt vermieden werden muß. Insbesondere muß auch der Saugabstand zwischen der Pipette und dem Bauelement innerhalb enger Toleranzgrenzen gehalten werden, um ein schlagfreies Abholen und Aufsetzen der Bauelemente zu ermöglichen.

Bei dem bekannten O-Ring ist die Deformierbarkeit so groß, daß derartige Genauigkeiten nicht sicher erreicht werden können. Insbesondere kann auch die beim Drehen des Revolverkopfes auftretende Fliehkraft der radial angesaugten Bauelemente zum Ablösen des eingepreßten O-Rings führen.

Ferner ist durch die JP-A-04 007 900 eine Saugpipette bekannt geworden, bei der in den Grundkörper korkenartig ein elastomerer Auflagekörper spielfrei eingesetzt ist, der den Grundkörper stirnseitig überragt und eine großflächige, vielfach gerippte Auflagefläche für das Bauelement aufweist. Eine zentrale Saugöffnung im elastomeren Auflagekörper leitet das Vakuum zur Stirnseite. Die Bohrung bildet auch einen Ausweichraum für das großvolumig vorhandene elastomere Material, so daß Dickenunterschiede der Bauelemente beim Aufsetzen auf die Leiterplatte federnd ausgeglichen werden können.

Der Erfindung liegt die Aufgabe zugrunde, die Lagegenauigkeit und die Bestücksicherheit zu erhöhen. Diese Aufgabe wird durch die Erfindung gemäß Anspruch 1 gelöst.

Durch die allseitige Abstützung des Auflagekörpers im Grundkörper ist der Auflagekörper weniger deformierbar und sicherer im Grundkörper gehalten. Die geringere Deformierbarkeit des Auflagekörpers verringert die elastische Auslenkung des angesaugten Bauelementes, so daß dieses in einer genaueren Seiten- und Höhenlage gegenüber der Pipette fixiert werden kann. Durch das allseitige Einspannen des Auflagekörpers im Grundkörper wird außerdem die Gefahr einer Lageveränderung durch Verdrehen oder Herausreißen verringert. Die vom Basisteil abgesetzte Auflagerippe kann im Querschnitt sehr schwach und der restliche Teil des Auflagekörpers stärker ausgebildet werden. Ein derartiger Auflagekörper läßt sich fertigungstechnisch leichter herstellen bzw. einsetzen. Die Auflagerippe wird aufgrund ihrer geringen Höhe nur wenig deformiert und kann sich dennoch Unebenheiten bzw. Schräglagen des Bauelementes anpassen. Durch die entsprechend schmale Anlagefläche zum Bauelement wird die Haftwirkung soweit verringert, daß das Bauelement nach dem Aufsetzen auf die Leiterplatte nicht an der Pipette haften bleibt. Die z.B. ringförmige Auflagerippe kann aufgrund ihrer geringen Stärke einen große Saugfläche umschließen, die eine entsprechend große Saugkraft ergibt, sodaß das Bauelement sicher gehalten werden kann.

Vorteilhafte Weiterbildungen der Erfindung sind in den Unteransprüchen gekennzeichnet:

Durch die Weiterbildung nach Anspruch 2 ist der Grundkörper im eingesetzten Bereich so fest eingespannt, daß er allenfalls noch an seiner freien Oberfläche geringfügig deformierbar ist.

Durch den bogenförmigen Querschnitt nach Anspruch 3 wird eine besonders schmale linienförmige Anlage des Bauelementes an der Auflagerippe erzielt.

Durch die Weiterbildung nach Anspruch 4 werden harte Schläge beim Aufsetzen des Bauelementes auf die Leiterplatte sicher vermieden.

Die Weiterbildung nach Anspruch 5 ergibt gleichmäßige Verformungsverhältnisse über die gesamte Erstreckung des z.B. ringförmigen Auflagekörpers. Durch das Anspritzen wird eine feste Verbindung und eine hohe Zuordnungsgenauigkeit erreicht.

Die rechteckförmige Aufnahmenut nach Anspruch 6 läßt sich spritzgußtechnisch einfach herstellen und ergibt gute Haftungseigenschaften gegenüber dem elastomeren Auflagekörper. Diese Haftungseigenschaften werden dadurch verbessert, daß der Grundkörper z.B. mit Glasfasern verstärkt ist, deren Enden geringfügig in die Aufnahmenut hineinragen und dadurch das Herausreißen des eingespritzten Auflagekörpers erschweren. Der fluchtende Abschluß der Außenseite mit dem Grundkörper ergibt eine optimale Abstützung der Auflagerippe.

Durch den Stützkörper nach Anspruch 7 wird erreicht, daß sich die Stützkraft mit zunehmender Verformung erhöht, so daß die Auflagerippen weniger verformt werden und die Lageabweichungen des Bauelementes gegenüber der Pipette, insbesondere die Höhenlage des Bauelementes in engeren Toleranzgrenzen gehalten werden kann. Durch die niedrigeren Stützflächen wird außerdem selbst bei einem Bauelement mit balliger Oberfläche eine sichere Anlage an der Auflagerippe erreicht.

Durch die Weiterbildung nach Anspruch 8 kann der Stützkörper in einem Zug mit dem Auflagekörper ohne zusätzliche Angußpunkte hergestellt werden.

Durch die Weiterbildung nach Anspruch 9 werden die Vorteile der Ausgestaltung des Auflagekörpers auch vom Stützkörper, insbesondere hinsichtlich der Verformungs- und Haftbedingungen genutzt.

Durch die Weiterbildung nach Anspruch 10 ergeben sich günstige Gießverhältnisse, bei denen die Stützstege in einfacher Weise vom Auflagekörper abgezweigt werden können.

Die schräg abfallenden stützrippen nach Anspruch 11 passen sich z.B. einem Bauelement mit balliger Saugfläche optimal an. Es wird somit mit stärker werdender Andrückkraft eine kontinuierlich vergrößerte Anlagefläche erreicht, ohne daß entlang der äußeren Auflagerippe ein Leck auftreten kann.

Im folgenden wird die Erfindung anhand eines in der Zeichnung dargestellten Ausführungsbeispieles näher erläutert.
- Figur 1: zeigt eine Ansicht einer Stirnseite einer Pipette zum Greifen von elektrischen Bauelementen,
- Figur 2: einen Schnitt durch die Pipette entlang der Linie II/II in Figur 1 mit einem elektrischen Bauelement.

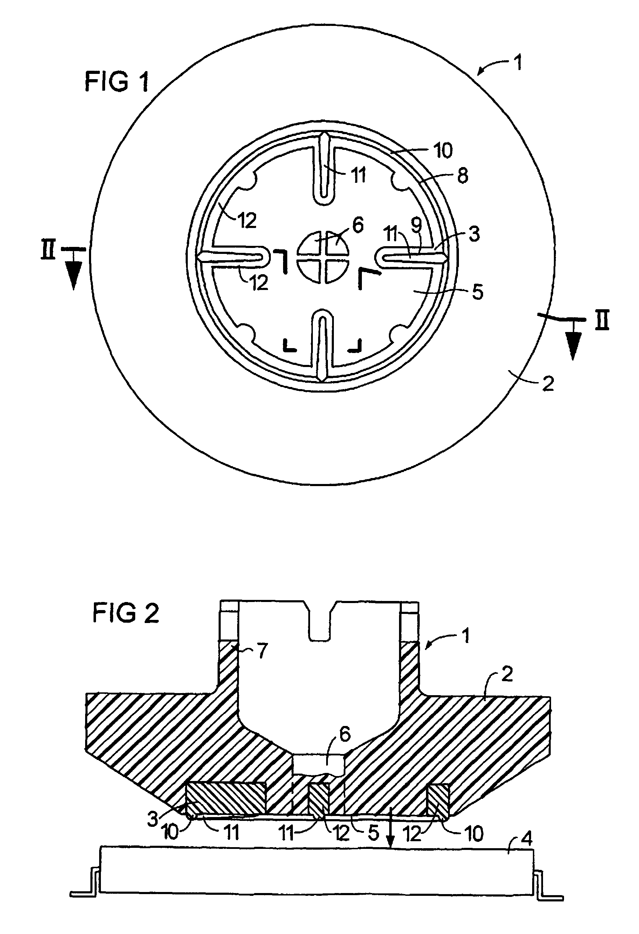

Nach den Figuren 1 und 2 besteht eine Pipette 1 aus einem Grundkörper 2 und einem elastomeren Einsatz 3, der in eine, einem elektrischen Bauelement 4 zugewandten Stirnseite 5 des drehsymmetrischen Grundkörpers 2 eingesetzt ist. Die Pipette 1 ist mit ihrer Stirnseite 5 gemäß dem senkrechten Pfeil in Figur 2 auf das Bauelement 4 aufsetzbar. Der Grundkörper 2 weist eine zur Stirnseite 5 durchgehende segmentierte zentrale Saugöffnung 6 auf, die an eine Vakuumquelle eines nicht dargestellten Bestückkopfes eines Bestückautomaten für Leiterplatten angeschlossen ist. Der Grundkörper 2 ist mit einem Haltering 7 zum Befestigen am Bestückkopf versehen.

Der elastomere Einsatz 3 ist einstückig aus einem ringförmig die Saugöffnung 6 umgebenden Auflagekörper 8 und Stützkörpern 9 zusammengesetzt, die sich vom Auflagekörper 8 aus speichenartig zur Saugöffnung 6 hin erstrecken. Der Auflagekörper 8 und die Stützkörper 9 weisen über die Stirnseite geringfügig hinausragende im Querschnitt halbkreisförmige Rippen, z.B. 10,11 auf. Diese sind zusammen mit einem dickeren stegartigen Basisteil 12 in entsprechend verlaufende, im Querschnitt rechteckförmige Aufnahmenuten des Grundkörpers eingegossen.

Die dem Auflagekörper 8 zugeordnete Auflagerippe 10 ist ringförmig umlaufend geschlossen. Sie überragt die Stirnseite um ihre halbe Breite. Die den Stützkörpern zugeordneten Stützrippen 11 verlaufen speichenartig von der Auflagerippe 10 aus nach innen schräg abfallend. Das bedeutet, daß sie mit zunehmender Andruckkraft an das Bauelement 4 entsprechend zunehmend wirksam werden. Durch die nach innen abnehmende Höhe der Stützrippen ist sichergestellt, daß ein Bauelement mit balliger Oberfläche sicher und spaltfrei auf der Auflagerippe aufliegt.

### Bezugszeichen

- 1: Pipette
- 2: Grundkörper
- 3: Einsatz
- 4: Bauelement
- 5: Stirnseite
- 6: Saugöffnung
- 7: Haltering
- 8: Auflagekörper
- 9: Stützkörper
- 10: Auflagerippe
- 11: Stützrippe
- 12: Basisteil

## Patentansprüche

1. Pipette (1) zum Greifen eines Bauelementes (4) mittels Vakuum, insbesondere beim Bestücken von Leiterplatten, wobei die Pipette (1) in einer dem Bauelement (4) zugewandten Stirnseite (5) eine Saugöffnung (6) aufweist,
wobei das Bauelement (4) gegen eine, die Saugöffnung (6) umgebende Auflagefläche der Stirnseite (5) ansaugbar ist, wobei die Auflagefläche Teil eines elastomeren Auflagekörpers (8) ist, der in einen Grundkörper (2) der Pipette (1) eingesetzt ist und der die Stirnseite (5) geringfügig überragt und
wobei der Grundkörper (2) der Pipette (1) den eingesetzten Teil des Auflagekörpers (8) mit Ausnahme der dem Bauelement (4) zugewandten Seite spielfrei umschließt.
**dadurch gekennzeichnet,**
daß der in die Stirnseite (5) des Grundkörpers (2) eingesetzte Auflagekörper (8) aus einem im Querschnitt dicken, vom Grundkörper allseitig umschlossenen Basisteil (12) und aus einer gegen dieses abgesetzten dünnen Auflagerippe (10) besteht, die die Auflagefläche bildet.

2. Pipette nach Anspruch 1,
**dadurch gekennzeichnet,**
daß der Auflagekörper (8) vom Grundkörper (2) hohlraumfrei umschlossen ist.

3. Pipette nach Anspruch 1 oder 2,
**dadurch gekennzeichnet,**
daß die Auflagerippe (10) im Querschnitt bogenförmig gekrümmt, insbesondere halbkreisförmig ausgebildet ist.

4. Pipette nach Anspruch 1,2 oder 3,
**dadurch gekennzeichnet,**
daß die Auflagefläche die Stirnseite (5) soweit überragt, daß das Bauelement (4) unter voller Andruckkraft den Grundkörper (2) nicht berührt.

5. Pipette nach einem der vorhergehenden Ansprüche, '
**dadurch gekennzeichnet,**
daß das stegartige dickere Basisteil (12) in seiner Längserstreckung der Auflagerippe (10) folgt,
daß der Grundkörper (2) zumindest eine entsprechende Aufnahmenut für das Basisteil (12) aufweist und
daß der Auflagekörper (8) in einem Gießverfahren an den Grundkörper (2) angeformt ist.

6. Pipette nach Anspruch 5,
**dadurch gekennzeichnet,**
daß die Aufnahmenut im Querschnitt rechteckförmig ausgebildet ist und
daß die Stirnseite des Basisteils (12) mit der Stirnseite (5) des Grundkörpers (2) mit Ausnahme der Auflagerippe (10) zumindest annähernd fluchtet.

7. Pipette nach einem der vorhergehenden Ansprüche,
**dadurch gekennzeichnet,**
daß in die Stirnseite (5) des Grundkörpers (2) zusätzlich zum Auflagekörper (8) zumindest ein elastomerer Stützkörper (9) mit stirnseitigen Stützflächen für das Bauelement (4) eingesetzt ist und
daß die Stützflächen niedriger liegen als die Auflageflächen des Auflagekörpers (8).

8. Pipette nach Anspruch 7,
**dadurch gekennzeichnet,**
daß der Stützkörper (9) mit dem Auflagekörper (8) einstückig verbunden ist.

9. Pipette nach Anspruch 7 oder 8,
**dadurch gekennzeichnet,**
daß der Stützkörper (9) stegartig ausgebildet ist und einen dem Auflagekörper (8) ähnlichen Querschnitt mit zumindest einer Stützrippe (11) aufweist, deren Außenseite die Stützfläche bildet und
daß der Stützkörper (9) innerhalb der von der Auflagerippe (10) umschlossenen Fläche angeordnet ist.

10. Pipette nach Anspruch 9,
**dadurch gekennzeichnet,**
daß der Auflagekörper (8) ringartig ausgebildet ist und
daß der Stützkörper (9) aus speichenartigen Stützstegen gebildet ist, die radial an den Auflagekörper (8) angesetzt sind.

11. Pipette nach Anspruch 10,
**dadurch gekennzeichnet,**
daß die Stützrippen (11) ausgehend von den Auflagerippen (10) nach innen schräg abfallend verlaufen.

## Claims

1. Pipette (1) for gripping a component (4) by means of vacuum, in particular when mounting components on printed circuit boards, the pipette (1) having a suction opening (6) in one end side (5) which faces towards the component (4), it being possible to suck the component (4) onto a bearing surface, which surrounds the suction opening (6), of the end side (5), the bearing surface forming part of an elastomeric bearing member (8) which is inserted into a base body (2) of the pipette (1) and projects slightly beyond the end side (5), and the base body (2) of the pipette (1) surrounding the inserted part of the bearing member (8), except for the side facing towards the component (4), without play, characterized in that the bearing member (8), which has been inserted into the end side (5) of the base body (2), comprises a base part (12), which has a thick cross section and is surrounded on all sides by the base body, and a thin bearing rib (10), which is smaller than the base part and forms the bearing surface.

2. Pipette according to Claim 1, characterized in that the bearing member (8) is surrounded by the base body (2) without there being any cavity.

3. Pipette according to Claim 1 or 2, characterized in that the bearing rib (10) is curved in the shape of an arc in cross section, and in particular is of semi-circular design.

4. Pipette according to Claim 1, 2 or 3, characterized in that the bearing surface projects beyond the end side (5) to such an extent that the component (4) does not touch the base body (2) even under full pressure.

5. Pipette according to one of the preceding claims, characterized in that the longitudinal extent of the web-like, thicker base part (12) follows the bearing rib (10), in that the base body (2) has at least one suitable receiving groove for the base part (12), and in that the bearing body (8) is cast onto the base body (2).

6. Pipette according to Claim 5, characterized in that the receiving groove is rectangular in cross section, and in that the end side of the base part (12) is at least approximately flush with the end side (5) of the base body (2), with the exception of the bearing rib (10).

7. Pipette according to one of the preceding claims, characterized in that, in addition to the bearing member (8), at least one elastomeric support member (9), with end-side support surfaces for the component (4), is inserted into the end side (5) of the base body (2), and in that the support surfaces are lower than the bearing surfaces of the bearing member (8).

8. Pipette according to Claim 7, characterized in that the support member (9) is joined to the bearing member (8) as a single piece.

9. Pipette according to Claim 7 or 8, characterized in that the support member (9) is of web-like design and has a cross section which is similar to that of the bearing member (8) with at least one support rib (11), the outside of which forms the support surface, and in that the support member (9) is arranged inside the area enclosed by the bearing rib (10).

10. Pipette according to Claim 9, characterized in that the bearing member (8) is of annular design, and in that the support member (9) is formed from spoke-like support webs which are fitted onto the bearing member (8) in the radial direction.

11. Pipette according to Claim 10, characterized in that the support ribs (11) are designed so as to slope obliquely downwards towards the inside, starting from the bearing ribs (10).

## Revendications

1. Pipette (1) pour saisir un composant (4) au moyen de la réalisation d'un vide, notamment pour l'implantation de composants sur des plaquettes à circuit imprimé,
la pipette (1) comportant une ouverture (6) d'aspiration dans une face (5) frontale tournée vers le composant (4),
le composant (4) pouvant être aspiré sur une surface de support de la face (5) frontale entourant l'ouverture (6) d'aspiration,
la surface de support faisant partie d'un corps (8) de support élastomère qui est introduit dans un corps (2) de base de la pipette (1) et qui fait légèrement saillie de la face (5) frontale et
le corps (2) de base de la pipette (1) entourant sans jeu la partie introduite du corps (8) de support à l'exception de la face tournée vers le composant (4),
caractérisée en ce que le corps (8) de support introduit dans la face (5) frontale du corps (2) de base est constitué d'une partie (12) de base épaisse en section transversale, entourée de tous les côtés par le corps de base, et d'une nervure (10) de support mince, décalée par rapport à la partie de base, qui forme la surface de support.

2. Pipette suivant la revendication 1, caractérisée en ce que le corps (8) de support est entouré du corps (2) de base sans former de cavité.

3. Pipette suivant la revendication 1 ou 2, caractérisée en ce que la nervure (10) de support est incurvée en forme d'arc en section transversale, notamment est de forme hémicirculaire.

4. Pipette suivant la revendication 1, ou 3, caractérisée en ce que la surface de support fait saillie de la face (5) frontale d'une distance telle que le composant (4) ne touche pas le corps (2) de base lorsque toute la force d'application est appliquée.

5. Pipette suivant l'une des revendications précédentes, caractérisée
en ce que la partie (12) de base plus épaisse du genre d'une barrette suit la nervure (10) de support dans son étendue longitudinale,
en ce que le corps (2) de base comporte au moins une rainure de réception correspondante pour la partie (12) de base et
en ce que le corps (8) de support est issu du corps (2) de base dans un procédé de moulage.

6. Pipette suivant la revendication 5, caractérisée
en ce que la rainure de réception est de section transversale rectangulaire et
en ce que la face frontale de la partie (12) de base est alignée au moins à peu près avec la face (5) frontale du corps (2) de base, à l'exception de la nervure (10) de support.

7. Pipette suivant l'une des revendications précédentes, caractérisée
en ce qu'un corps (9) de soutien élastomère à surface de soutien côté frontal est introduit pour le composant (4) dans la face (5) frontale du corps (2) de base en plus du corps (8) de support et
en ce que les surfaces de soutien se trouvent plus bas que !es surfaces de support du corps (8) de support.

8. Pipette suivant la revendication 7, caractérisée en ce que le corps (9) de soutien est relié d'un seul tenant au corps (8) de support.

9. Pipette suivant la revendication 7 ou 8, caractérisée
en ce que le corps (9) de soutien est réalisé à la façon d'une barrette et a une section transversale similaire au corps (8) de support, avec au moins une nervure (11) de soutien dont la face extérieure forme la surface de soutien et
en ce que le corps (9) de soutien est prévu à l'intérieur de la surface entourée par la nervure (10) de support.

10. Pipette suivant la revendication 9, caractérisée
en ce que le corps (8) de support est réalisé à la façon d'un anneau et
en ce que le corps (9) de soutien est formé de barrettes de soutien du genre de rayons qui sont rattachées radialement au corps (8) de support.

11. Pipette suivant la revendication 10, caractérisée en ce que les nervures (11) de soutien s'étendent en descendant en biais vers l'intérieur à partir des nervures (10) de support.
